(19)

Europäisches
Patentamt

European
Patent Office

Office européen
des brevets

(11)  **EP 4 722 293 A1**

(12)  **EUROPEAN PATENT APPLICATION**
published in accordance with Art. 153(4) EPC

(43) Date of publication:
**08.04.2026  Bulletin 2026/15**

(21) Application number: **24845647.7**

(22) Date of filing: **24.07.2024**

(51) International Patent Classification (IPC):
*C08L 63/00* (2006.01)      *C08K 3/08* (2006.01)
*C08K 3/12* (2006.01)      *C08K 3/32* (2006.01)
*C08L 33/04* (2006.01)      *C08L 51/04* (2006.01)
*H01B 1/22* (2006.01)      *H05K 1/09* (2006.01)

(52) Cooperative Patent Classification (CPC):
**C08K 3/08; C08K 3/12; C08K 3/32; C08L 33/04;
C08L 51/04; C08L 63/00; H01B 1/22; H05K 1/09**

(86) International application number:
**PCT/JP2024/026437**

(87) International publication number:
**WO 2025/023272 (30.01.2025 Gazette 2025/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority:  **27.07.2023  JP 2023122285**

(71) Applicants:
• **Tatsuta Electric Wire & Cable Co., Ltd.
Higashiosaka-shi, Osaka 578-8585 (JP)**
• **Copprint Technologies Ltd
9330317 Jerusalem (IL)**

(72) Inventors:
• **UMEDA, Hiroaki
Kizugawa-shi, Kyoto 619-0216 (JP)**
• **NISHIYAMA, Satoru
Kizugawa-shi, Kyoto 619-0216 (JP)**
• **SAKAGUCHI, Mitsuhiro
Kizugawa-shi, Kyoto 619-0216 (JP)**
• **GROUCHKO, Michael
9330317 Jerusalem (IL)**

(74) Representative: **Dolleymores
9 Rickmansworth Road
Watford, Hertfordshire WD18 0JU (GB)**

(54)  **METHOD FOR PRODUCING HIGHLY CONDUCTIVE COMPOSITION AFTER DRYING AND FIRING**

(57)    A conductive composition contains: (A) 1.005 mass% to 1.74 mass% of a bisphenol type epoxy resin; (B) 0.015 mass% or more and less than 0.08 mass% of a (meth)acrylic resin having a weight average molecular weight of 1,000 or more and 400,000 or less; (C) 0.5 mass% to 0.86 mass% of polymer particles containing a polybutadiene rubber; (D) 5 mass% to 95 mass% of copper particles having an average particle diameter of 2 nm to 500 nm; (E) 0.9 mass% to 4.8 mass% of silver particles having an average particle diameter of 2 nm to 500 nm; (F) 0.001 mass% to 20 mass% of a phosphorus-containing compound; (G) 0.0001 mass% to 10 mass% of CuH; and (H) 0.1 mass% to 90 mass% of a solvent.

EP 4 722 293 A1

**Description**

Technical Field

The present invention relates to formulations for producing highly conductive composition after drying and sintering.

Background Art

As a method of forming a conductive pattern on a base material, a method of printing a conductive composition on a base material is known. As a conductive composition used for such printing, for example, PTL 1 discloses a conductive composition containing copper nanoparticles, a phosphorus-containing compound, and copper hydride (CuH).
However, such a conductive composition has room for improvement in adhesion to a base material, in particular, adhesion to a flexible printed circuit board (FPC), and conductivity.

Citation List

Patent Literature

PTL 1: Japanese Patent No. 6959977

Summary of Invention

Technical Problem

The invention is made in view of the above, and an object of the invention is to provide a conductive composition having both excellent conductivity and adhesion.

Solution to Problem

The invention includes aspects shown below.

[1] A conductive composition comprising:

(A) 1.005 mass% to 1.74 mass% of a bisphenol type epoxy resin;
(B) 0.015 mass% or more and less than 0.08 mass% of a (meth)acrylic resin having a weight average molecular weight of 1,000 or more and 400,000 or less;
(C) 0.5 mass% to 0.86 mass% of polymer particles containing a polybutadiene rubber;
(D) 5 mass% to 95 mass% of copper particles having an average particle diameter of 2 nm to 500 nm;
(E) 0.9 mass% to 4.8 mass% of silver particles having an average particle diameter of 2 nm to 500 nm;
(F) 0.001 mass% to 20 mass% of phosphorus-containing compound;
(G) 0.0001 mass% to 10 mass% of CuH; and
(H) 0.1 mass% to 90 mass% of a solvent.

[2] The conductive composition according to [1], in which

the polymer particles (C) have a core-shell structure including a core layer and a shell layer,
the core layer contains a polybutadiene rubber, and
the shell layer is made of a polymer of a vinyl-based monomer.

[3] The conductive composition according to [1] or [2], in which a content ratio ((D)/(E)) of the copper particles (D) to the silver particles (E) is 15.0 to 45.0 in terms of mass ratio.
[4] The conductive composition according to any one of [1] to [3], in which a total content ratio of the copper particles (D) and the silver particles (E) is 11.6 mass% to 83.8 mass%.

Advantageous Effects of Invention

According to the conductive composition of the invention, excellent conductivity and adhesion can be obtained.

Brief Description of Drawings

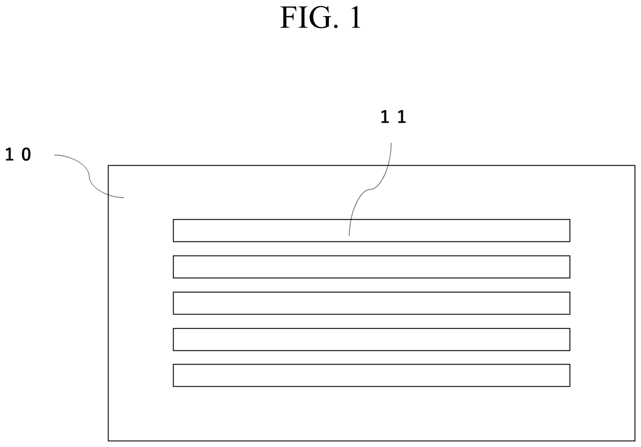

[FIG. 1] FIG. 1 is a schematic diagram of a sample used for evaluation of conductivity in Examples.

Description of Embodiments

Hereinafter, embodiments of the invention will be described in more detail.

A conductive composition according to the present embodiment contains: (A) 1.005 mass% to 1.74 mass% of a bisphenol type epoxy resin; (B) 0.015 mass% or more and less than 0.08 mass% of a (meth)acrylic resin having a weight average molecular weight of 1,000 or more and 400,000 or less; (C) 0.5 mass% to 0.86 mass% of polymer particles containing a polybutadiene rubber; (D) 5 mass% to 95 mass% of copper particles having an average particle diameter of 2 nm to 500 nm; (E) 0.9 mass% to 4.8 mass% of silver particles having an average particle diameter of 2 nm to 500 nm; (F) 0.001 mass% to 20 mass% of a phosphorus-containing compound; (G) 0.0001 mass% to 10 mass% of CuH; and (H) 0.1 mass% to 90 mass% of a solvent.

In the present specification, the "weight average molecular weight" is a value that can be measured by gel permeation chromatography (GPC), using refractive index detector (RI) as a detector, using "TSKgel G4000HXL" manufactured by Tosoh Corp. as a column, using tetrahydrofuran as a mobile phase, using Commercial standard polystyrene and calculated by using a calibration curve in terms of the polystyrene, with the measurement temperature at 40°C, flow rate at 1.0 mL/min, and injection volume at 50 $\mu$L.

Examples of the bisphenol type epoxy resin (A) include a bisphenol A type epoxy resin, a bisphenol F type epoxy resin, and a bisphenol S type epoxy resin. These resins may be used alone or in combination.

An epoxy equivalent of the bisphenol type epoxy resin (A) is not particularly limited, and is preferably 200 g/eq to 350 g/eq, more preferably 230 g/eq to 330 g/eq, and still more preferably 240 g/eq to 320 g/eq. When the epoxy equivalent is 200 g/eq or more, cracks are less likely to occur after printing on a base material. When the epoxy equivalent is 350 g/eq or less, adhesion to a base material is improved, and long-term reliability of adhesion and conductivity is likely to be improved.

A content ratio of the bisphenol type epoxy resin (A) is 1.005 mass% to 1.74 mass%, preferably 1.131 mass% to 1.678 mass%, and more preferably 1.257 mass% to 1.616 mass%.

The (meth)acrylic resin (B) is a polymer containing at least an acrylic acid ester and/or a methacrylic acid ester as a constituent monomer. For example, a polymer containing at least one selected from the group consisting of methyl acrylate, ethyl acrylate, propyl acrylate, n-butyl acrylate, isobutyl acrylate, methyl methacrylate, ethyl methacrylate, propyl methacrylate, n-butyl methacrylate, and isobutyl methacrylate, as the constituent monomer can be used. The constituent monomer may contain a monomer other than the acrylic acid ester or the methacrylic acid ester within a range not contrary to the object of the invention. When containing two or more kinds of monomers, the polymer may be an alternating copolymer, a random copolymer, a block copolymer, or a graft copolymer. Here, the "(meth)acrylic resin" is a generic term for "acrylic resin" and "methacrylic resin".

A weight average molecular weight of the (meth)acrylic resin (B) is 1,000 or more, preferably 5,000 or more, more preferably 7,000 or more, and still more preferably 10,000 or more. The weight average molecular weight is 400,000 or less, preferably 200,000 or less, more preferably 150,000 or less, and still more preferably 50,000 or less.

As such a (meth)acrylic resin (B), for example, a copolymer for firing paste according to JP2016-155920A, JP2015-59196A, JP2016-196606A, and WO2016/132814 can be used. A commercially available (meth)acrylic resin can also be used. For example, "KC-1100" and "KC-1700P" manufactured by Kyoeisha Chemical Co., Ltd. can be used.

A content ratio of the (meth)acrylic resin (B) is 0.015 mass% or more and less than 0.08 mass%, preferably 0.015 mass% to 0.075 mass%, and more preferably 0.02 mass% to 0.075 mass%.

The polymer particles (C) may be any particles containing a polybutadiene rubber. It is preferable that the polymer particles (C) have a core-shell structure made of a core layer and a shell layer, the core layer contains a polybutadiene rubber, and the shell layer is made of a polymer of a vinyl-based monomer. Examples of the vinyl-based monomer include: styrene-based monomers such as styrene, $\alpha$-methylstyrene, monochlorostyrene, and dichlorostyrene; (meth)acrylic acid-based monomers such as methyl acrylate, ethyl acrylate, propyl acrylate, n-butyl acrylate, methyl methacrylate, ethyl methacrylate, propyl methacrylate, and n-butyl methacrylate; and unsaturated nitrile-based monomers such as acrylonitrile and methacrylonitrile.

The polymer constituting the shell layer is preferably grafted to the core layer.

A content ratio of the polymer particles (C) is 0.5 mass% to 0.86 mass%, preferably 0.557 mass% to 0.827 mass%, and more preferably 0.619 mass% to 0.796 mass%.

An average particle diameter of the polymer particles (C) is not particularly limited, and is preferably 30 nm to 500 nm, and more preferably 50 nm to 300 nm. The "average particle diameter" of the polymer particles (C) means a number-based average particle diameter D50 (median diameter) measured by using "MT3000II" manufactured by MicrotracBEL Corp. as a laser diffraction/scattering type particle size distribution analyzer, under the condition that the polymer particles (C) are dispersed in pure water.

A content ratio of the copper particles (D) having the average particle diameter of 2 nm to 500 nm is 5 mass% to 95 mass%, preferably 40 mass% to 79 mass%, more preferably 60 mass% to 79 mass%, and still more preferably 65 mass% to 75 mass%.

The average particle diameter of the copper particles (D) is preferably 10 nm to 500 nm, and more preferably 20 nm to 400 nm. In the present specification, the "average particle diameter" of metal particles means a number-based average particle diameter D50 (median diameter) measured by using "MT3000II" manufactured by MicrotracBEL Corp. as a laser diffraction/scattering type particle size distribution analyzer, after adding butylcarbitol to the metal particles and dispersing the particles in the butylcarbitol by an ultrasonic vibrator for 10 minutes.

A shape of the copper particles (D) is not particularly limited, and a spherical shape, a flaked shape (scale-like shape), a dendritic shape, or a fibrous shape can be used, and a spherical shape or a flaked shape (scale-like shape) is preferable. The "spherical" metal particles include not only substantially perfect-spherical particles (atomized powder) but also substantially spherical particles such as substantially polyhedral spherical particles (reduced powder) and amorphous particles (electrolytic powder).

A content ratio of the silver particles (E) having the average particle diameter of 2 nm to 500 nm is 0.9 mass% to 4.8 mass%, preferably 1.69 mass% to 4.5 mass%, and more preferably 1.69 mass% to 4.2 mass%.

The average particle diameter of the silver particles (E) is preferably 30 nm to 400 nm, and more preferably 60 nm to 300 nm.

A shape of the silver particles (E) is not particularly limited, and a spherical shape, a flaked shape (scale-like shape), a dendritic shape, or a fibrous shape can be used, and a spherical shape or a flaked shape (scale-like shape) is preferable. The "spherical" metal particles include not only substantially perfect-spherical particles (atomized powder) but also substantially spherical particles such as substantially polyhedral spherical particles (reduced powder) and amorphous particles (electrolytic powder).

A content ratio ((D)/(E)) of the copper particles (D) to the silver particles (E) is not particularly limited, and is preferably 15.0 to 45.0, and more preferably 16.0 to 42.0.

A total content ratio of the copper particles (D) and the silver particles (E) is not particularly limited, and is preferably 11.6 mass% to 83.8 mass%, more preferably 42 mass% to 80 mass%, more preferably 62 mass% to 78 mass%, and still more preferably 67 mass% to 75 mass%.

A content ratio of the phosphorus-containing compound (F) is 0.001 mass% to 20 mass%, preferably 0.003 mass% to 20 mass%, more preferably 0.005 mass% to 15 mass%, more preferably 1 mass% to 14 mass%, more preferably 3 mass% to 13 mass%, and still more preferably 5 mass% to 12 mass%.

The phosphorus-containing compound (F) acts as a copper oxidizing agent and oxidizes at least a part of copper (Cu) into cuprous ions ($Cu^+$) to form copper hydride (CuH). CuH may be formed as nanoparticles or flakes containing substantially pure CuH, but most of CuH is formed on copper (Cu) nanoparticles, that is, as a continuous coating layer of CuH, or as a CuH domain (that is, a discontinuous coating), on at least a part of the copper particles.

In some embodiments, the phosphorus-containing compound may be selected from hypophosphorous acid, phosphorous acid, phosphoric acid, pyrophosphoric acid ($H_4P_2O_7$), tripolyphosphoric acid ($H_5P_3O_{10}$), tetrapolyphosphoric acid ($H_6P_4O_{13}$), trimetaphosphoric acid ($H_3P_3O_9$), phosphoric anhydride ($P_4O_{10}$), polyphosphoric acid, hypophosphoric acid ($H_4P_2O_6$), pyrophosphorous acid ($H_4P_2O_5$), and metaphosphorous acid ($HPO_2$), and mixtures thereof.

In other embodiments, the phosphorus-containing compound is hypophosphorous acid (HPA, also known as phosphinic acid), having the chemical formula $HOP(O)H_2$.

A ratio between the phosphorus-containing compound and the copper particles (the phosphorus-containing compound/the copper particles) is preferably 0.001 to 0.2 in terms of mass ratio in some embodiments. That is, the phosphorus-containing compound is contained in a ratio of 0.1 mass% to 20 mass% with respect to 1 part by mass of the copper particles.

A content ratio of the copper hydride (G) is 0.0001 mass% to 10 mass%, preferably 0.0003 mass% to 8 mass%, more preferably 1 mass% to 7 mass%, and still more preferably 3 mass% to 6 mass%, regardless of a form thereof.

Although it is not desired to be bound by theory, CuH can function as a protective layer against oxidation from copper to copper oxide. Further, once applied onto a base material and heated, CuH is decomposed to provide an $H_2$ atmosphere, which prevents formation of copper oxide and realizes sintering of copper particles by an intermetallic interaction.

In some embodiments, CuH may be crystalline or amorphous. In some other embodiments, CuH may be amorphous (for example, not showing a clear peak in XRD analysis).

Since the conductive composition of the invention is subjected to various heating processes, the solvent (H) is desirably selected to have a boiling point at which the solvent (H) can evaporate when exposed to the heating process. In some embodiments, the solvent (H) can be selected to have a different evaporation rate and/or boiling point from that of the phosphorus-containing compound. For example, the solvent (H) may have a higher boiling point and/or a lower evaporation rate than that of the phosphorus-containing compound. In other embodiments, when the phosphorus-containing compound is desired to be present in a dry pattern, the solvent (H) may be selected to have a lower boiling point and/or a higher evaporation rate than that of the phosphorus-containing compound. Specifically, the solvent (H) may be selected from: water; alcohols such as terpineol, and propylene glycol; glycol ethers such as ethylene glycol monomethyl ether, ethylene glycol monoethyl ether, ethylene glycol monopropyl ether, ethylene glycol monoisopropyl ether, ethylene glycol monobutyl ether, ethylene glycol monophenyl ether, ethylene glycol monobenzyl ether, ethylene glycol monohexyl ether, diethylene glycol monomethyl ether, diethylene glycol monoethyl ether, diethylene glycol mono-n-butyl ether, diethylene glycol monohexyl ether, dipropylene glycol methyl ether, and tripropylene glycol methyl ether; glycol ether acetates (preferably alkoxy alkyl acetates) such as ethylene glycol monomethyl ether acetate, ethylene glycol monoethyl ether acetate, ethylene glycol monopropyl ether acetate, ethylene glycol monoisopropyl ether acetate, ethylene glycol monobutyl ether acetate, ethylene glycol monophenyl ether acetate, ethylene glycol monobenzyl ether acetate, ethylene glycol monohexyl ether acetate, diethylene glycol monomethyl ether acetate, diethylene glycol monoethyl ether acetate, diethylene glycol mono-n-butyl ether acetate, diethylene glycol monohexyl ether acetate, diethylene glycol n-butyl ether acetate, 1-methoxymethyl acetate, 3-methoxypropyl acetate, 3-ethoxypropyl acetate, 2-methoxypropyl acetate, 2-ethoxypropyl acetate, 2-methoxybutyl acetate, 2-ethoxybutyl acetate, 3-methoxybutyl acetate, 3-ethoxybutyl acetate, 4-methoxybutyl acetate, 4-ethoxybutyl acetate, 2-methoxypentyl acetate, 2-ethoxypentyl acetate, 3-methoxypentyl acetate, 3-ethoxypentyl acetate, 4-methoxypentyl acetate, 4-ethoxypentyl acetate, 5-methoxypentyl acetate, 5-ethoxypentyl acetate, and 3-methoxy-3-methylbutyl acetate; and a mixture thereof.

A content ratio of the solvent (H) is 0.1 mass% to 90 mass%, preferably 5 mass% to 80 mass%, more preferably 7 mass% to 35 mass%, and still more preferably 10 mass% to 30 mass%. In one embodiment, the content ratio of the solvent (H) may be 10 mass% to 90 mass%.

The conductive composition of the invention is obtained by blending predetermined amounts of the respective components described above and sufficiently mixing these components.

The conductive composition of the invention may contain an additive that is added to the same type of conductive composition in the related art within a range that does not deviate from the object of the invention. Examples of the additive include a curing catalyst, an antifoaming agent, a thickener, a tackifier, a filler, an anti-settling agent, a colorant, an antioxidant, a plasticizer, an ultraviolet absorber, and a flame retardant.

A viscosity of the conductive composition of the invention is not particularly limited, and may be appropriately adjusted according to a coating method or an apparatus used therefor. As a guide, the viscosity at a liquid temperature of 25°C is preferably 500 dPa·s to 2,500 dPa·s, and more preferably 1,000 dPa·s to 2,000 dPa·s.

In the present specification, the "viscosity of the conductive composition" means a viscosity measured at a rotation speed of 10 rpm using VISCOMETER TVB-10 (manufactured by Toki Sangyo Co., Ltd.) spindle No. 7.

The conductive composition of the invention can be applied to a base material by any appropriate application method, for example, inkjet printing, screen printing, spin coating, roll coating, spray coating, dip coating, flow coating, doctor blade coating, dispensing, offset printing, pad printing, gravure printing, flexographic printing, stencil printing, imprinting, xerography, lithography, stamping, or any other appropriate application methods.

The conductive pattern formed on the base material can be formed on any appropriate base material. The base material is a flexible or rigid, stretchable or bendable, absorptive or non-absorptive, conductive or non-conductive, colored or transparent base material, and may have a substantially two-dimensional surface (thin flat base material), a three-dimensional curved surface (not flat), or a uniform or non-uniform surface, or the like. A surface of the base material may have any smoothness. Most generally, the base material may be a solid material such as a metal, glass, paper, a semiconductor, a polymer material, and a ceramic surface, or a hybrid base material containing some different materials. In particular, when a polymer material (for example, a polyimide resin, a polyester resin, a polyamide resin, or a polyamide-imide resin) used for a flexible printed circuit board (FPC) is used as the base material, an effect of improving the adhesion of the conductive composition of the invention is easily exhibited. A material constituting the surface of the base material to which the conductive composition is applied does not necessarily have to be the same material as most of the base material. In some embodiments, the surface is substantially two-dimensional. In other embodiments, the surface is a surface of a three-dimensional object or article.

The base material can have a uniform surface made of a single material (or a single composition), that is, a substantially uniform surface roughness and/or a uniform thickness. However, in the context of the present disclosure, it should be noted that the surface may be non-uniform. That is, the surface of the base material includes at least two portions, which may be different from each other in at least one of roughness, height, thickness, material, composition, or the like. The at least two portions may be integrated with each other or may have a gap therebetween (that is, the portions of the base material may be continuously associated with each other). For example, one portion of the base material is a tube, and the other portion of the base material is a cap coupled to the tube, so that a small gap can be formed between the tube and the cap. Therefore, the method of the present disclosure can be applied to continuous printing on a base material having a plurality of portions.

The "surface" may be the entire surface or any region thereof. The "region" may have any size and structure. These regions may be continuous, may be integrated with each other, or may include some regions that are discontinuously spaced apart from each other. In some embodiments, the regions are integrated with each other. These "regions" also refer to a plurality of regions, and at least two of the plurality of regions are different from each other in at least one characteristic (that is, composition, texture, thickness, and the like). Therefore, this term means that a plurality of regions different from other plurality of regions are also included depending on the characteristic, and all the regions are formed on the surface or a part thereof.

The conductive composition of the invention is formed as a pattern on the base material and then subjected to a heating process. At this time, CuH is decomposed, and Cu nanoparticles are sintered together in order to obtain a conductive pattern.

The term "sinter" refers to formation of a continuous matrix of individual granular materials by a heating process. When the granular materials are heated, diffusion of metal atoms between adjacent contact particles is promoted, so that a continuous metal matrix having reduced porosity is formed. By sintering, a non-conductive pattern made of copper nanoparticles is converted into a continuous conductive copper matrix (or grid).

A method for obtaining the conductive pattern on the base material by using the conductive composition of the invention includes: a step 1 of obtaining a pattern-carrying base material by printing the conductive composition of the invention on at least a surface region of the base material; and a step 2 of exposing the pattern-carrying base material to conditions enabling the decomposition of CuH and the sintering of copper and silver. The step 2 is a period of about 0.01 seconds to 600 seconds. Accordingly, the conductive pattern is obtained.

In some embodiments, the conditions enabling the decomposition of CuH and the sintering of copper and silver can include exposing the pattern-carrying base material to a temperature of 125°C or higher. In other embodiments, the base material may be exposed to a temperature of about 125°C to 500°C. Sintering at a temperature higher than 500°C or lower than 125°C (for example, about 50°C to 125°C) is also intended.

In some other embodiments, the pattern-carrying base material is exposed to a high temperature (at least 125°C) over a period of about 0.01 seconds to 600 seconds. Although it is not desired to be bound by theory, the higher the sintering temperature, the shorter an exposure period of the pattern-carrying base material to such a temperature. As will be understood by a person skilled in the art, the pattern may be exposed to a single (that is, uniform) temperature throughout the entire sintering temperature, or may be exposed to a varying temperature profile. For example, the sintering process may include two or more steps performed in different exposure periods and at different temperatures. A change in temperature may be gradual (that is, the temperature may be increased or decreased at various rates) or may be abrupt (rapid increase or decrease in temperature).

The decomposition of CuH and the sintering of copper and silver may be performed in an air atmosphere or in a localized reducing atmosphere, that is, an atmosphere of gaseous reducing species. The reducing atmosphere can be obtained in situ by decomposition of CuH and phosphorus-containing compound to form a gaseous reducing agent (for example, formation of hydrogen as a decomposition product). Alternatively, the reducing atmosphere can be obtained by introducing the gaseous reducing species during the sintering.

The decomposition of CuH and sintering may be performed immediately after application of a formulation or at any time thereafter. The sintering process may include heating a pattern-carrying surface by any appropriate method such as lamp flashes of heat lamps (xenon, NIR, and the like), UV lamps, lasers, hot air, ovens, or any other heat treatment units.

The sintering may be selectively performed. The selective sintering means sintering of a selected portion or a plurality of portions of the pattern, and a desired portion of the pattern is sintered, and other portions are not sintered. Such selective sintering can be obtained, for example, by exposing a printing pattern to a radiation source (for example, infrared rays or near-infrared rays) through an appropriate blocking mask. The mask may be detachably disposed on the printing pattern before the exposure to the radiation source, or may be disposed between the radiation source and a patterned surface. The selective sintering can also be obtained by other suitable methods such as laser scanning.

As described above, during the sintering process, the printing pattern is heated to a high temperature for a predetermined period of time during which one or a plurality of processes occur. That is, when the temperature rises, CuH is decomposed, reactivity between copper and the phosphorus-containing compound is increased (accordingly, further CuH is formed), and/or phosphorus-containing compound can be decomposed. These processes are highly exothermic and cause a local extreme and steep temperature rise in the printing pattern.

Further, due to an exothermic effect and local heating as a result of a chemical reaction, it is intended that the sintering can be performed at a low temperature, that is, in a lower sintering temperature range described in the present specification.

Examples

Hereinafter, Examples of the invention will be shown, and the invention is not limited to these Examples. In the following, unless otherwise specified, a blending ratio and the like are based on mass.

According to formulation (content, mass%) shown in Tables 1 to 3 below, respective components were mixed to prepare a conductive composition.

·Bisphenol type epoxy resin (A1): bisphenol A type epoxy resin with epoxy equivalent of 270 g/eq
·Bisphenol type epoxy resin (A2): bisphenol F type epoxy resin with epoxy equivalent of 226 g/eq,
·Glycidyl amine-based epoxy resin: glycidyl amine-based epoxy resin with epoxy equivalent of 124 g/eq,
·(Meth)acrylic resin (B): weight average molecular weight = 17,000, a polymer of isobutyl methacrylate
·Polymer particles (C1): average particle diameter = 100 nm, butadiene rubber polymer particles having a core-shell structure (core layer: polybutadiene rubber, shell layer: polymer of vinyl-based monomer)
·Polymer particles (C2): average particle diameter = 100 nm, styrene-butadiene rubber polymer particles having a core-shell structure (core layer: styrene-butadiene rubber, shell layer: polymer of vinyl-based monomer)
·Copper particles (D): average particle diameter = 100 nm
·Silver particles (E): average particle diameter = 150 nm, spherical shape
·Phosphorus-containing compound (F): hypophosphorous acid
·Copper hydride (G): CuH
·Solvent (H1): 3-methoxy-3-methylbutyl acetate
·Solvent (H2): diethylene glycol monobutyl ether

Conductivity and adhesion of the obtained conductive composition were evaluated. Results are shown in Tables 1 to 3. An evaluation method is as follows.

<Conductivity>

The conductive composition according to each of Examples and Comparative Examples was applied to a prepared polyimide film 10 having a length of 100 mm, a width of 65 mm, and a thickness of 50 μm, using a 420-mesh Tetron printing plate and a urethane squeegee, as shown in FIG. 1. After drying at 85°C for 2 minutes in an air oven, pressing was performed at a surface pressure of 1 MPa and a temperature of 200°C for 1 minute to obtain a sample in which five cured products 11 each having a length of 70 mm and a width of 2 mm were formed. Resistance values (R, Q) of the cured products 11 were measured by a precision tester, and an average value was obtained. A thickness of each cured product 11 was measured with a micrometer, and a volume resistivity (Ω·cm) was calculated based on a sample cross-sectional area (S, cm$^2$) and a sample length (L, cm) according to the following equation (1). When the volume resistivity was $2.5 \times 10^{-5}$ Ω·cm or less, the conductivity was evaluated as excellent.

Volume resistivity = (sample cross-sectional area (S)/sample length (L)) × resistance value (R) (1)                    (1)

<Adhesion: Cross Cut Test>

The conductive composition according to each of Examples and Comparative Examples was applied in a length of 60 mm and a width of 60 mm to a prepared polyimide film having a length of 100 mm, a width of 65 mm, and a thickness of 50 μm, using a 420-mesh Tetron printing plate and a urethane squeegee. After drying at 85°C for 2 minutes in an air oven, pressing was performed at a surface pressure of 1 MPa and a temperature of 200°C for 1 minute to obtain a sample in which the conductive composition was cured. The obtained sample was evaluated by performing a cross cut test according to ASTM D 3359. In addition, chipping was also evaluated, and chip-free samples were marked with "P", and chipped samples with "F". When no chipping was present and evaluation according to ASTM D 3359 was 4B or higher, the adhesion was evaluated as excellent.

[Table 1]

|  | Ex. 1 | Ex. 2 | Ex. 3 | Ex. 4 | Ex. 5 | Ex. 6 | Ex. 7 |
|---|---|---|---|---|---|---|---|
| Formulation (mass%) |  |  |  |  |  |  |  |
| Bisphenol type epoxy resin (A1) | 1.25 | 1.56 | 1.60 | 1.59 | 1.57 | 1.71 | 0.00 |
| Bisphenol type epoxy resin (A2) | 0.00 | 0.00 | 0.00 | 0.00 | 0.00 | 0.00 | 1.74 |
| Meth)acrylic resin(B) | 0.07 | 0.07 | 0.03 | 0.04 | 0.06 | 0.07 | 0.07 |
| Polymer particles (C1) | 0.62 | 0.77 | 0.79 | 0.78 | 0.77 | 0.84 | 0.58 |
| Copper particles (D) | 68.22 | 67.91 | 69.86 | 69.19 | 68.54 | 67.75 | 67.91 |
| Silver particles (E) | 4.14 | 4.12 | 1.69 | 2.52 | 3.32 | 4.11 | 4.12 |

(continued)

|  | Ex. 1 | Ex. 2 | Ex. 3 | Ex. 4 | Ex. 5 | Ex. 6 | Ex. 7 |
|---|---|---|---|---|---|---|---|
| Formulation (mass%) |  |  |  |  |  |  |  |
| Phosphorus-containing compound (F) | 9.35 | 9.30 | 9.57 | 9.48 | 9.39 | 9.28 | 9.30 |
| Copper hydride (G) | 4.67 | 4.65 | 4.78 | 4.74 | 4.69 | 4.64 | 4.65 |
| Solvent (H1) | 0.47 | 0.47 | 0.19 | 0.28 | 0.38 | 0.46 | 0.47 |
| Solvent (H2) | 11.21 | 11.16 | 11.48 | 11.37 | 11.27 | 11.14 | 11.16 |
| Evaluation |  |  |  |  |  |  |  |
| Conductivity ($\times 10^{-5}\Omega\cdot$cm) | 1.2 | 1.2 | 2.2 | 2.4 | 2 | 1.7 | 1.6 |
| Adhesion to polyimide (cross hatch chipping) | P | P | P | P | P | P | P |
| Adhesion to polyimide (cross hatch) | 5B | 5B | 4B | 5B | 5B | 5B | 5B |

[Table 2]

|  | Comp. Ex. 1 | Comp. Ex. 2 | Comp. Ex. 3 | Comp. Ex. 4 | Comp. Ex. 5 | Comp. Ex. 6 | Comp. Ex. 7 |
|---|---|---|---|---|---|---|---|
| Formulation (mass%) |  |  |  |  |  |  |  |
| Bisphenol type epoxy resin (A1) | 0.00 | 0.63 | 0.94 | 1.57 | 1.86 | 2.46 | 1.74 |
| Glycidylamine-based epoxy resin | 0.00 | 0.00 | 0.00 | 0.00 | 0.00 | 0.00 | 0.00 |
| (Meth)acrylic resin (B) | 0.07 | 0.07 | 0.07 | 0.00 | 0.07 | 0.07 | 0.07 |
| Polymer particles (C1) | 0.00 | 0.31 | 0.46 | 0.77 | 0.92 | 1.21 | 0.00 |
| Polymer particles (C2) | 0.00 | 0.00 | 0.00 | 0.00 | 0.00 | 0.00 | 0.58 |
| Copper particles (D) | 69.52 | 68.87 | 68.54 | 68.27 | 67.59 | 66.97 | 67.91 |
| Silver particles (E) | 4.21 | 4.17 | 4.15 | 4.14 | 4.10 | 4.06 | 4.12 |
| Phosphorus-containing compound (F) | 9.52 | 9.43 | 9.39 | 9.35 | 9.26 | 9.17 | 9.30 |
| Copper hydride (G) | 4.76 | 4.72 | 4.69 | 4.68 | 4.63 | 4.59 | 4.65 |
| Solvent (H1) | 0.48 | 0.47 | 0.47 | 0.00 | 0.46 | 0.46 | 0.47 |
| Solvent (H2) | 11.43 | 11.32 | 11.27 | 11.22 | 11.11 | 11.01 | 11.16 |
| Evaluation |  |  |  |  |  |  |  |
| Conductivity ($\times 10^{-5}\Omega\cdot$cm) | 1.2 | 2.2 | 0.7 | 1.0 | 3.2 | 5.6 | 2.1 |
| Adhesion to polyimide (cross hatch chipping) | F | F | F | F | P | P | F |
| Adhesion to polyimide (cross hatch) | 4B | 4B | 2B | 0B | 5B | 5B | 0B |

[Table 3]

|  | Comp. Ex. 8 | Comp. Ex. 9 | Comp. Ex. 10 | Comp. Ex. 11 |
|---|---|---|---|---|
| Formulation (mass%) |  |  |  |  |
| Bisphenol type epoxy resin (A1) | 1.62 | 0.00 | 1.54 | 0.00 |
| Glycidylamine-based epoxy resin | 0.00 | 1.74 | 0.00 | 0.00 |
| (Meth)acrylic resin (B) | 0.01 | 0.07 | 0.08 | 0.00 |

(continued)

| | Comp. Ex. 8 | Comp. Ex. 9 | Comp. Ex. 10 | Comp. Ex. 11 |
|---|---|---|---|---|
| Formulation (mass%) | | | | |
| Polymer particles (C1) | 0.80 | 0.00 | 0.76 | 0.00 |
| Polymer particles (C2) | 0.00 | 0.58 | 0.00 | 0.00 |
| Copper particles (D) | 70.53 | 67.91 | 67.28 | 73.00 |
| Silver particles (E) | 0.86 | 4.12 | 4.89 | 0.00 |
| Phosphorus-containing compound (F) | 9.66 | 9.30 | 9.22 | 10.00 |
| Copper hydride (G) | 4.83 | 4.65 | 4.61 | 5.00 |
| Solvent (H1) | 0.10 | 0.47 | 0.55 | 0.00 |
| Solvent (H2) | 11.59 | 11.16 | 11.06 | 12.00 |
| Evaluation | | | | |
| Conductivity ($\times 10^{-5}\Omega\cdot$cm) | 2.3 | 40 | 1.6 | 0.8 |
| Adhesion to polyimide (cross hatch chipping) | F | P | F | F |
| Adhesion to polyimide (cross hatch) | 3B | 5B | 2B | 0B |

From the results shown in Tables 1 to 3, it is found that all of Examples 1 to 7 are excellent in conductivity and adhesion.

Comparative Example 1 is an example in which the bisphenol type epoxy resin (A) and the polymer particles (C) containing polybutadiene rubber are not contained, and Comparative Example 2 is an example in which the content ratio thereof is less than a lower limit value, and the adhesion is poor.

Comparative Example 3 is an example in which the content ratio of the bisphenol type epoxy resin (A) is less than a lower limit value, and the adhesion is poor.

Comparative Example 4 is an example in which the (meth)acrylic resin (B) is not contained, and the adhesion is poor.

Comparative Examples 5 and 6 are examples in which the content ratio of polymer particles (C) containing the polybutadiene rubber exceeds the higher limit value, and the conductivities are poor.

Comparative Example 7 is an example in which polymer particles containing styrene-butadiene rubber are contained instead of polymer particles (C) containing polybutadiene rubber, and the adhesion is poor.

Comparative Example 8 is an example in which the content ratio of silver particles (E) is less than the lower limit value, and the adhesion is poor.

Comparative Example 9 is an example in which glycidyl amine-based epoxy resin is contained instead of the bisphenol type epoxy resin (A) and polymer particles (C) containing the polybutadiene rubber are not contained, and the conductivity is poor.

Comparative Example 10 is an example in which the content ratio of silver particles (E) and the content ratio of the (meth)acrylic resin (B) exceed the higher limit value, and the adhesion is poor.

Comparative Example 11 is an example in which component (A), component (B), component (C), and component (E) are not contained, and the adhesion is poor.

Reference Signs List

    10: polyimide film
    11: cured product of conductive composition

**Claims**

1.    A conductive composition comprising:

(A) 1.005 mass% to 1.74 mass% of a bisphenol type epoxy resin;

(B) 0.015 mass% or more and less than to 0.08 mass% of a (meth)acrylic resin having a weight average molecular weight of 1,000 or more and 400,000 or less;

(C) 0.5 mass% to 0.86 mass% of polymer particles containing a polybutadiene rubber;

(D) 5 mass% to 95 mass% of copper particles having an average particle diameter of 2 nm to 500 nm;

(E) 0.9 mass% to 4.8 mass% of silver particles having an average particle diameter of 2 nm to 500 nm;

(F) 0.001 mass% to 20 mass% of a phosphorus-containing compound;

(G) 0.0001 mass% to 10 mass% of CuH; and

(H) 0.1 mass% to 90 mass% of a solvent.

2. The conductive composition according to claim 1, wherein

the polymer particles (C) have a core-shell structure including a core layer and a shell layer,
the core layer contains a polybutadiene rubber, and
the shell layer is made of a polymer of a vinyl-based monomer.

3. The conductive composition according to claim 1 or 2, wherein a content ratio ((D)/(E)) of the copper particles (D) to the silver particles (E) is 15.0 to 45.0 in terms of mass ratio.

4. The conductive composition according to any one of claims 1 to 3, wherein a total content ratio of the copper particles (D) and the silver particles (E) is 11.6 mass% to 83.8 mass%.

# FIG. 1

## INTERNATIONAL SEARCH REPORT

International application No.

**PCT/JP2024/026437**

### A. CLASSIFICATION OF SUBJECT MATTER

*C08L 63/00*(2006.01)i; *C08K 3/08*(2006.01)i; *C08K 3/12*(2006.01)i; *C08K 3/32*(2006.01)i; *C08L 33/04*(2006.01)i;
*C08L 51/04*(2006.01)i; *H01B 1/22*(2006.01)i; *H05K 1/09*(2006.01)i
FI:  C08L63/00 Z; C08L33/04; C08L51/04; C08K3/08; C08K3/12; C08K3/32; H05K1/09 D; H01B1/22 Z

According to International Patent Classification (IPC) or to both national classification and IPC

### B. FIELDS SEARCHED

Minimum documentation searched (classification system followed by classification symbols)

C08L63/00-63/10; C08K3/00-13/08; C08L33/00-33/26; C08L51/00-51/10; C08L9/00-9/10; H01B1/00-1/24; H01B5/00-5/16;
H05K1/09

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| A | WO 2021/220557 A1 (TATSUTA ELECTRIC WIRE & CABLE CO., LTD.) 04 November 2021 (2021-11-04)<br>claims, examples | 1-4 |
| A | JP 2019-529587 A (COPPRINT TECHNOLOGIES LTD.) 17 October 2019 (2019-10-17)<br>claims | 1-4 |
| A | JP 2014-222611 A (ISHIHARA CHEMICAL CO., LTD.) 27 November 2014 (2014-11-27)<br>claims | 1-4 |
| A | JP 2012-23096 A (THE YOKOHAMA RUBBER CO., LTD.) 02 February 2012 (2012-02-02)<br>claims | 1-4 |
| A | WO 2018/211887 A1 (TATSUTA ELECTRIC WIRE & CABLE CO., LTD.) 22 November 2018 (2018-11-22)<br>claims | 1-4 |

☐ Further documents are listed in the continuation of Box C.  ☑ See patent family annex.

| | | | |
|---|---|---|---|
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | "&" | document member of the same patent family |
| "P" | document published prior to the international filing date but later than the priority date claimed | | |

| Date of the actual completion of the international search | Date of mailing of the international search report |
|---|---|
| **24 September 2024** | **15 October 2024** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (July 2022)

## INTERNATIONAL SEARCH REPORT
### Information on patent family members

International application No.

**PCT/JP2024/026437**

| Patent document cited in search report | | | Publication date (day/month/year) | Patent family member(s) | | | Publication date (day/month/year) |
|---|---|---|---|---|---|---|---|
| WO | 2021/220557 | A1 | 04 November 2021 | US 2023/0151228 A1 claims, examples CN 115397915 A KR 10-2023-0005118 A | | | |
| JP | 2019-529587 | A | 17 October 2019 | US 2019/0177566 A1 claims CN 109563363 A KR 10-2019-0039942 A | | | |
| JP | 2014-222611 | A | 27 November 2014 | US 2016/0029483 A1 claims CN 105210156 A KR 10-2015-0138331 A | | | |
| JP | 2012-23096 | A | 02 February 2012 | (Family: none) | | | |
| WO | 2018/211887 | A1 | 22 November 2018 | CN 109563388 A KR 10-2020-0010284 A | | | |

Form PCT/ISA/210 (patent family annex) (July 2022)

13

**EP 4 722 293 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6959977 B
- JP 2016155920 A
- JP 2015059196 A
- JP 2016196606 A
- WO 2016132814 A